# EUROPEAN PATENT APPLICATION

(11) **EP 2 571 062 A2**
(43) Date of publication of application: **20.03.2013**
(21) Application number: 12181389.3
(22) Date of filing: 22.08.2012
(51) Int. Cl.: H01L 31/048, H01L 31/052

(54) **Solar module**

(30) Priority: 19.09.2011 TW 100133623
(71) Applicant: AU Optronics Corporation, Hsin-Chu (TW)
(72) Inventor: Tseng, Huang-Chi, Hsin-Chu (TW); Wang, Yao-Chang, Hsin-chu (TW); Su, Wei-Sheng, Hsin-chu (TW)
(74) Representative: Lang, Christian

(57) **Abstract**

A solar module includes a back sheet, a solar cell unit, and a cover sheet. The back sheet includes a substrate, and a rib formed on the substrate. The solar cell unit is disposed on the back sheet next to the rib. In addition, the solar cell unit includes a bottom surface facing the back sheet and a light-receiving surface disposed opposite to the bottom surface. The cover sheet is disposed on the solar cell unit. A first height from a top surface of the substrate to an upper end of the rib is greater than a second height from the top surface of the substrate to the bottom surface of the solar cell unit, and the first height is not greater than a third height from the top surface of the substrate to a lower surface of the cover sheet facing the solar cell unit.

## Description

### RELATED APPLICATIONS

This application claims priority to Taiwan Application Serial Number 100133623, filed September 19, 2011, which is herein incorporated by reference.

### BACKGROUND

### Technical field

The present disclosure relates to a solar module. More particularly, the present disclosure relates to a back sheet of a solar module.

### Description of Related Art

A solar module includes the main elements of solar cells, a back sheet, and packaging material filled between the solar cells and the back sheet. The solar cells are connected to each other by welding strips, and then the solar cells are sealed by the encapsulant after the encapsulant is heated to a specific temperature in a lamination process. However, as a result of the fact that the encapsulant is heated in a pressurized and vacuum pressure state, the solar cells are easily displaced and contact each other, thereby causing a short-circuit. A typical way in which this problem is dealt with involves attaching heat-resistant adhesive tape to the back sides of the solar cells to decrease the amount of displacement of the same.

### SUMMARY

A solar module is provided as an aspect of the invention. The solar module includes a back sheet, a solar cell unit, and a cover sheet. The back sheet includes a substrate, and a rib formed on the substrate. The solar cell unit is disposed on the back sheet and next to the rib. In addition, the solar cell unit includes a bottom surface facing the back sheet and a light-receiving surface disposed opposite to the bottom surface. The cover sheet is disposed on the solar cell unit. A first height from a top surface of the substrate to an upper end of the rib is greater than a second height from the top surface of the substrate to the bottom surface of the solar cell unit, and the first height is not greater than a third height from the top surface of the substrate to a lower surface of the cover sheet facing the solar cell unit.

The solar cell units can be aligned by the ribs on the back sheet to maintain a space between the solar cell units and to prevent the solar cell units from undergoing displacement during a lamination process. In addition, the ribs can reflect incident light to thereby further increase the efficiency of the solar module.

### BRIEF DESCRIPTION OF THE DRAWINGS

The invention can be more fully understood by reading the following detailed description of the embodiment, with reference made to the accompanying drawings as follows:
Fig. 1 is a top view of an embodiment of a solar module of the invention;
Fig. 2 is a cross-section of the solar module along a sectional line A-A of Fig. 1;
Fig. 3A to Fig. 3G are schematic diagrams of different embodiments of back sheets of the invention;
Fig. 4 is a bar chart of cell to module (CTM) efficiency losses when utilizing different back sheets; and
Fig. 5A to Fig. 5C are cross-sections of different embodiments of solar modules combined with encapsulant of the invention.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

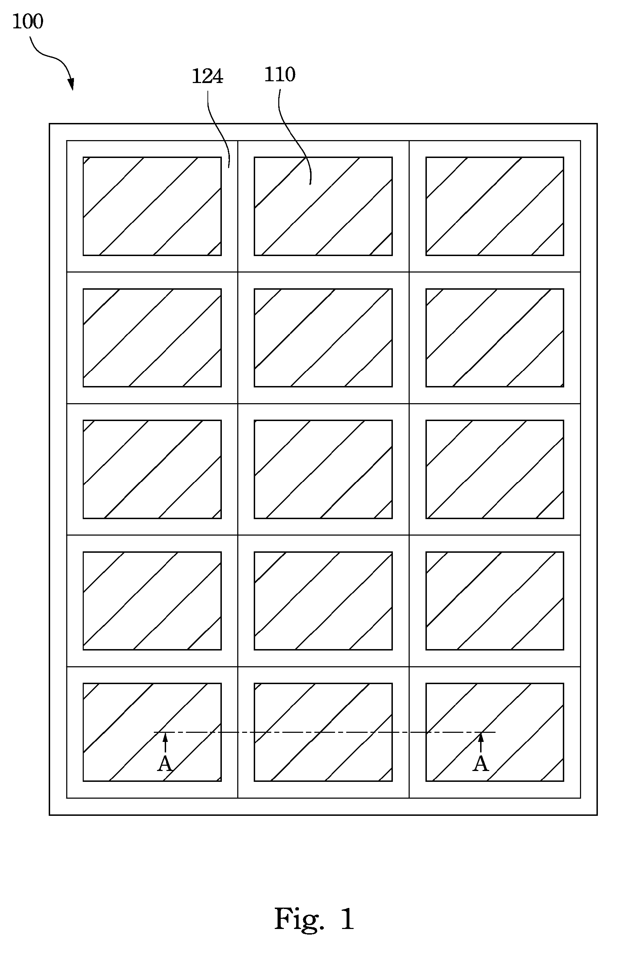

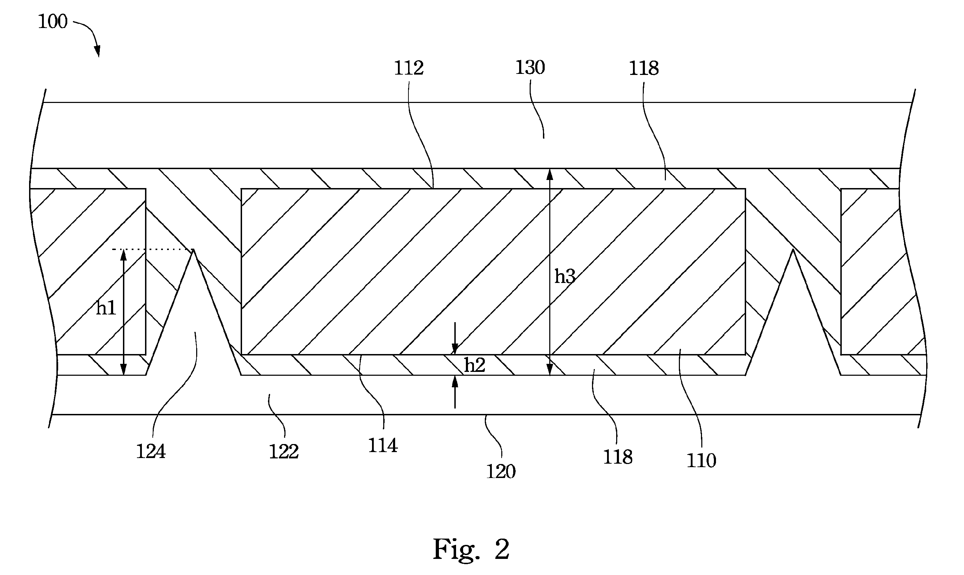

Fig. 1 is a top view of an embodiment of a solar module of the invention. The solar module 100 includes plural solar cell units 110 and a back sheet 120 (see Fig. 2). The solar cell units 110 are disposed in rows and columns on the back sheet 120. The back sheet 120 has plural ribs 124, and the solar cell units 110 are disposed next to the ribs 124. Gaps between the solar cell units 110 are maintained by the ribs 124. The ribs 124 may be parallel to each other. The ribs 124 are arranged in rows and columns, thereby forming a lattice array. The ribs 124 may surround the solar cell units 110. The ribs 124 can be contacted with the solar cell units 110 or spatially separated from the solar cell units 110. More particularly, there is a plurality of receiving spaces defined by the ribs 124, and the solar cell units 110 are disposed in the receiving spaces respectively.

Fig. 2 is a cross-section of the solar module along a sectional line A-A of Fig. 1. The solar module 100 includes the solar cell units 110, the back sheet 120, a cover sheet 130. The solar module 100 may further include an encapsulant 118. The solar cell units 110 are disposed between the back sheet 120 and the cover sheet 130. Each of the solar cell units 110 includes a light-receiving surface 112 facing upwardly (i.e., the cover sheet 130) to receive light from the sun, and a bottom surface 114 located opposite to the light-receiving surface 112 and which faces the back sheet 120. The back sheet 120 is located under the bottom surfaces 114 of the solar cell units 110. In other words, the solar cell units 110 are located on the back sheet 120, and hence, the back sheet 120 may be described as carrying the solar cell units 110. The back sheet 120 includes a substrate 122 and at least one of the ribs 124 formed on the substrate 122. In the case where one rib 124 is formed on the substrate 122 and one solar cell unit 110 disposed on the back sheet 120, the rib 124 is disposed next to the solar cell unit 110. The cover sheet 130 is disposed on the solar cell units 110. The encapsulant 118 is disposed between the light-receiving surface 112 of each of the solar cell units 110 and the cover sheet 130 and/or the bottom surface 114 of each of the solar cell units 110 and the back sheet 120.

The ribs 124 and the substrate 122 can be integrally formed by roll forming, plastic injection, or indentation processes. A first height h1 from the top of any one of the ribs 124 to the top surface of the substrate 122 is greater than a second height h2 from the bottom surface 114 of any one of the solar cell units 110 to the top surface of the substrate 122. In other words, the first height h1 of any one of the ribs 124 protruding from the top surface of the substrate 122 is greater than the second height h2 that extends from the bottom surface 114 of any one of the solar cell units 110 to the top surface of the substrate 122. The first height h1 represents a shortest distance between the top of any one of the ribs 124 to the top surface of the substrate 122, and the second height h2 represent a shortest distance between the bottom surface 114 of any one of the solar cell units 110 to the top surface of the substrate 122. Accordingly, the ribs 124 can align the solar cell units 110 to eliminate the possibility of displacement of the solar cell units 110 during manufacture. The first height h1 from any one of the ribs 124 to the top surface of the substrate 122 may be not greater than a third height h3 from a lower surface of the cover sheet 130 facing the solar cell units 110 to the top surface of the substrate 122. With this configuration, the ribs 124 protrude from the top surface of the substrate 122 and extend between the solar cell units 110. However, as a result of the fact that the ribs 124 do not extend past the light-receiving surfaces 112 of the solar cell units 110, the ribs 124 are located between the back sheet 120 and the cover sheet 130 after the ribs 124 and the solar cell units 110 are packaged.

When assembling the solar module 100, the back sheet 120 having the ribs 124 is provided. Subsequently, the encapsulant 118 is disposed on the back sheet 120. The encapsulant 118 can be, for example, an EVA adhesive material or another encapsulant. The encapsulant 118 can also be formed using a plurality of sheets that are disposed on the substrate 122 between the ribs 124, that is, at locations corresponding to the positions of the solar cell units 110. In other embodiments, the encapsulant 118 can also be disposed on the whole surface of the back sheet 120 including on the ribs 124.

Next, the solar cell units 110 are put on the back sheet 120, and the solar cell units 110 are disposed next to the ribs 124 in a manner extending between the ribs 124. The encapsulant 118 is disposed between the solar cell units 110 and the ribs 124. The ribs 124 align the solar cell units 110 and limits the distance the solar cell units 110 are displaced during the lamination process to solve appearance defects caused by improper alignment of the solar cell units 110.The ribs 124 may be designed having a particular sectional profile (i.e., a particular cross-sectional shape) to enhance the usage rate of light. The sectional profile of the ribs is a protrusion. Specifically, in the embodiment shown in Fig. 2, the sectional profile of the ribs 124 is in the form of a triangle, or a shape in which a center thereof protrudes upwardly. Hence, the height of the ribs 124 at centers thereof is greater than the height of the ribs 124 at edges thereof. This structural feature forms a side surface of the ribs 124 into an oblique surface facing the solar cell units 110 so that incident light is reflected by the ribs 124 toward the solar cell units 110 to thereby raise the usage rate of light and achieve a higher electricity generating efficiency of the solar module 100. Compared to general solar cells disposed with an additional concentrated structure, the solar module 100 utilizing the ribs 124 combined with the back sheet 120 of this disclosure need not dispose an extra concentrated structure such that cost savings are realized.

Subsequently, the cover sheet 130 coated with the encapsulant 118 is disposed on the solar cell units 110. The surface of the cover sheet 130 that is coated with the encapsulant 118 faces the solar cell units 110. Hence, the solar cell units 110 are disposed between two layers of the encapsulant 118. The cover sheet 130 can be, for example, a transparent glass.

After the back sheet 120, the solar cell unit 110, the encapsulant 118, and the cover sheet 130 are placed, a lamination process is performed. During the lamination process, the solar module 100 is heated and pressed. Pressure and heat used during the lamination process make the encapsulant 118 melt and surround the solar cell units 110. Moreover, the encapsulant 118 may fill the space between the cover sheet 130 and the back sheer 120, such that the cover sheet 130 and the solar cell units 110 are sealed by the encapsulant 118, and the solar cell units 110 and the back sheet 120 are also sealed by the encapsulant 118. The packaging process is completed when all the encapsulant 118 is bonded to these elements.

The solar module 100 prevents the solar cell units 110 from being displaced during the lamination process through use of the ribs 124 of the back sheet 120 which align the solar cell units 110.

It is noted that for the following description, the description provided with respect to the above embodiments will not be repeated. Only a description related to the back sheet 120 is further discussed. The sectional profile of the ribs 124 can be different, as long as the sectional profile of the ribs 124 is such that a center thereof protrudes upwardly. Namely the height of the ribs 124 at the center thereof is greater than the height of the ribs 124 at edges thereof, and the side surface of each of the ribs 124 facing the corresponding solar cell unit 110 can reflect incident light toward the solar cell unit 110 to raise the usage rate of light of the solar module 100.

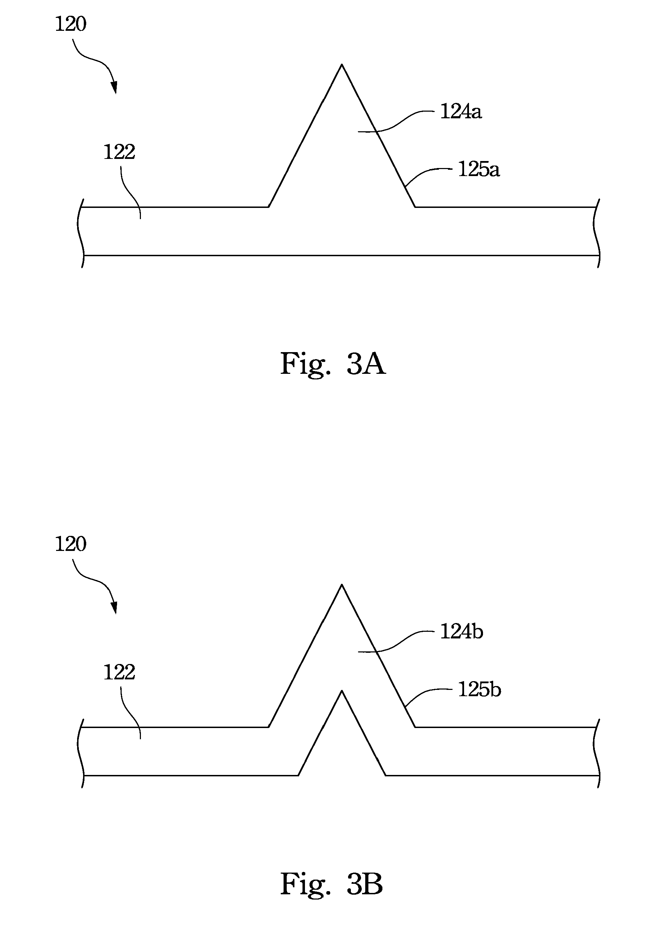

Fig. 3A to Fig. 3G are schematic diagrams of different embodiments of back sheets of the invention. In each of Figs. 3A to 3G, only a portion of the back sheet 120 including one of the ribs 124 is shown to simplify the description to follow.

In Fig. 3A, a rib 124a is a solid structure. The rib 124a and the substrate 122 can be fabricated by plastic injection. A sectional profile of the rib 124a is triangular. A side surface 125a of the rib 124a is formed as an oblique surface facing the corresponding solar cell units (see Fig. 1).

In Fig. 3B, a rib 124b is a hollow structure. The rib 124b and the substrate 122 can be fabricated by roll forming, plastic injection, or indentation. A sectional profile of the rib 124b is triangular, or more precisely, inverted V-shaped due to the hollow structure thereof. A side surface 125b of the rib 124b is formed as an oblique surface facing the corresponding solar cell units (see Fig 1).

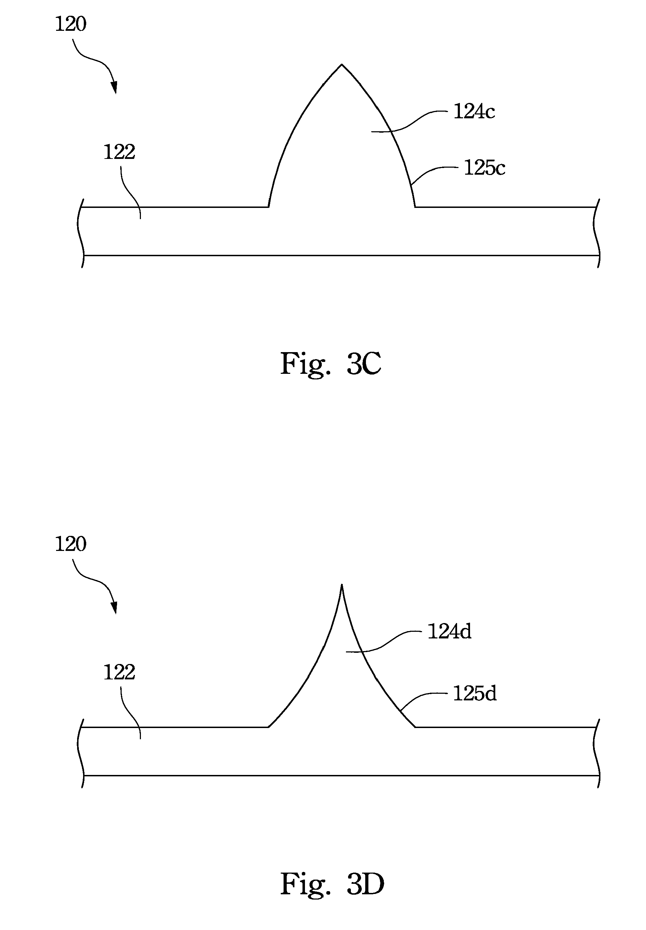

In Fig. 3C, a rib 124c is a solid structure. The rib 124c and the substrate 122 can be fabricated by plastic injection. A sectional profile of the rib 124c is bullet-shaped. A side surface 125c of the rib 124c is formed as an outwardly curved surface facing the corresponding solar cell units (see Fig. 1).

In Fig. 3D, a rib 124d is a solid structure. The rib 124d and the substrate 122 can be fabricated by plastic injection. A sectional profile of the rib 124d is roughly conical. A side surface 125d of the rib 124d is formed as in inwardly curved surface facing the corresponding solar cell units (see Fig. 1).

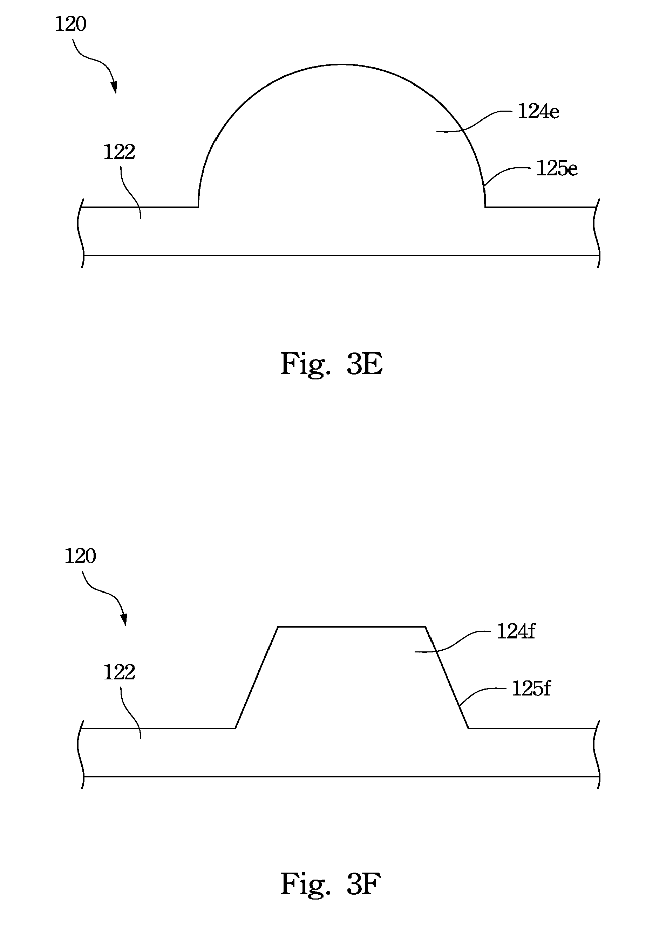

In Fig. 3E, a rib 124e is a solid structure. The rib 124e and the substrate 122 can be fabricated by plastic injection. A sectional profile of the rib 124e is spherical. A side surface 125e of the rib 124e is formed as an outwardly rounded surface facing the corresponding solar cell units (see Fig. 1).

In Fig. 3F, a rib 124f is a solid structure. The rib 124f and the substrate 122 can be fabricated by plastic injection. The sectional profile of the rib 124f is trapezoidal. A side surface 125f of the rib 124f is formed as an oblique surface facing the corresponding solar cell units (see Fig. 1).

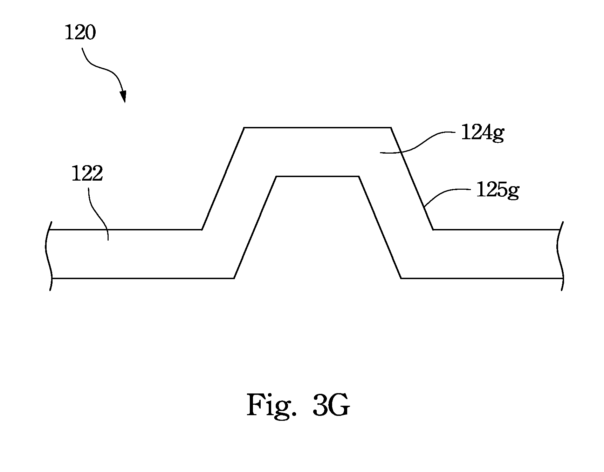

In Fig. 3G, a rib 124g is a hollow structure. The rib 124g and the substrate 122 can be fabricated by plastic or injection indentation. The sectional profile of the rib 124g is trapezoidal, or more precisely, inverted U-shaped with outwardly angled sides due to the hollow structure thereof. A side surface 125g of the rib 124g is an oblique surface facing the corresponding solar cell units (see Fig. 1).

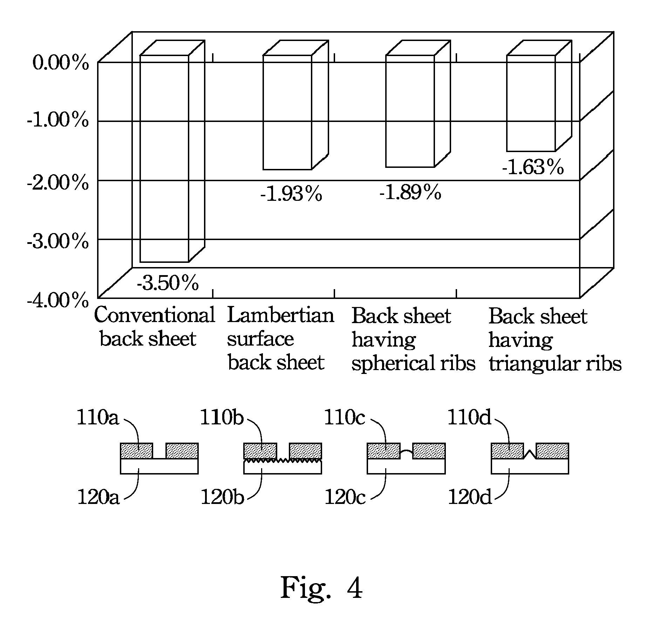

Fig. 4 is a bar chart of cell to module (CTM) efficiency losses when utilizing different back sheets. The chart lists the efficiency losses of solar modules utilizing four different back sheets, namely, a conventional back sheet 120a, a Lambertian surface back sheet 120b, a back sheet 120c having spherical ribs of this disclosure, and a back sheet 120d having triangular ribs of this disclosure.

According to the chart, the efficiency loss of the solar module utilizing the conventional back sheet 120a without any surface treatment, in which solar cell units 110a are directly disposed on the conventional back sheet 120a, reaches 3.5%. The efficiency loss of the solar module utilizing the Lambertian surface back sheet 120b having a wavy surface is 1.93%, in which solar cell units 110b are disposed on the Lambertian surface back sheet 120b and the wavy surface is positioned under the solar cell units 110b. The solar module of this disclosure utilizing the back sheet 120c having spherical ribs extending between solar cell units 110c is able to raise the usage rate of light, so that the efficiency loss thereof is reduced to 1.89%. The solar module utilizing a back sheet 120d having triangular ribs extending between the solar cell units 110d can reflect light to the solar cell units 110d more efficiently, so that the efficiency loss thereof is further reduced to 1.63%.

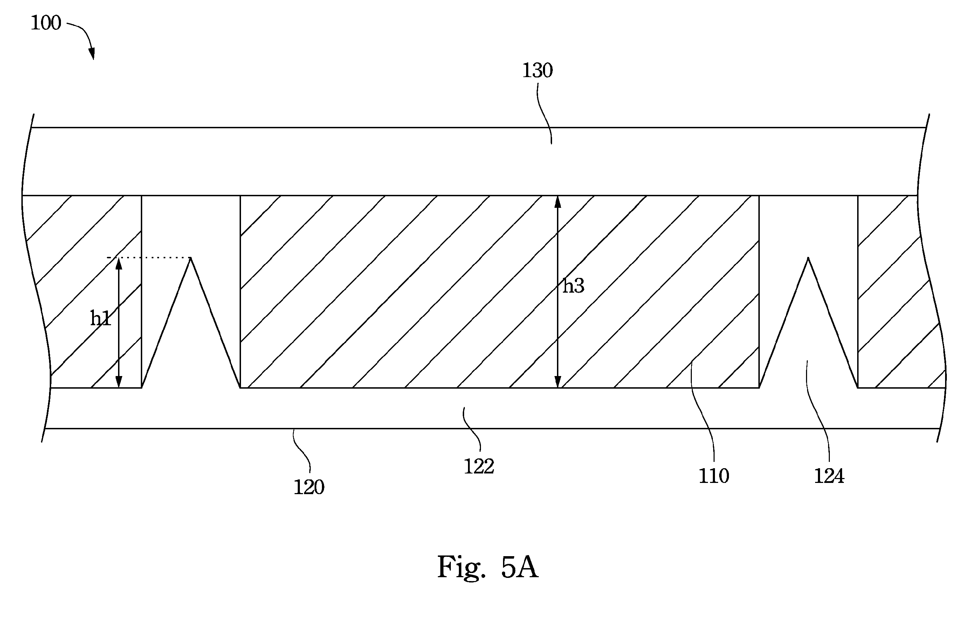

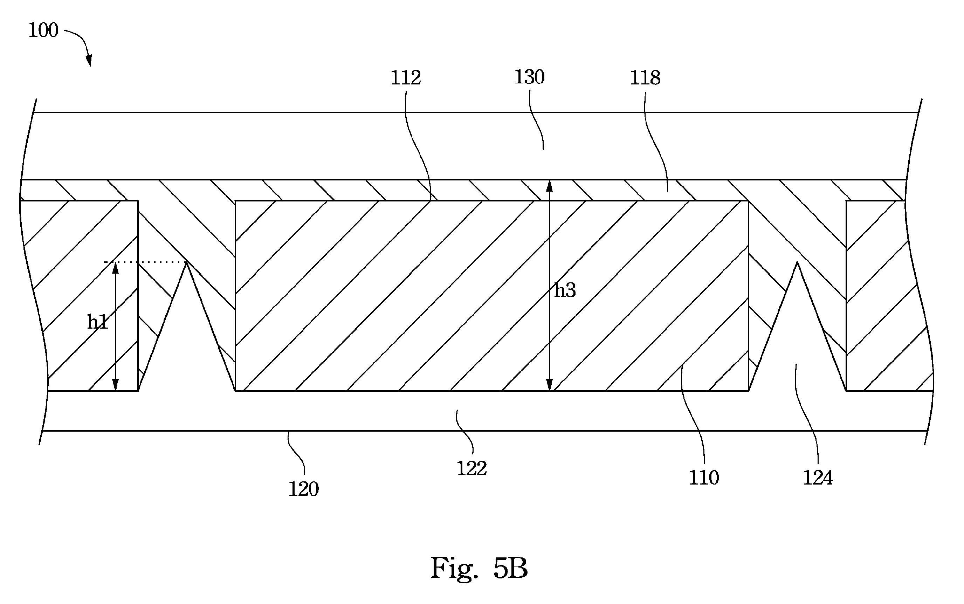

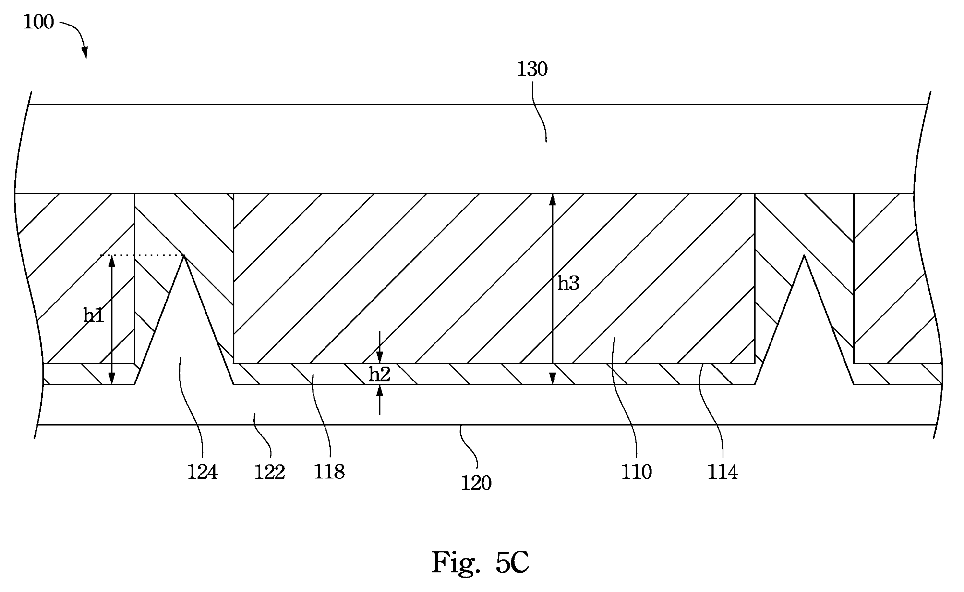

Fig. 5A to Fig. 5C are cross-sections of different embodiments of solar modules combined with encapsulant of the invention. The encapsulant 118 can be selectively used as required because the ribs 124 have the effect to align. As shown in Fig. 5A, the solar module 100 does not include the encapsulant 118. The solar cell units 110 can be well positioned between the cover sheet 130 and the back sheet 120 with the ribs 124. Alternatively, as shown in Fig 5B, the encapsulant 118 can be located between the light-receiving surface 112 of each of the solar cell units 110 and the cover sheet 130 in the solar module 100 as required, and the encapsulant 118 is melt and fills the space between the cover sheet 130 and the back sheet 120 during the lamination process. As shown in Fig. 5C, the encapsulant 118 can be located between the bottom surface 114 of each of the solar cell units 110 and the back sheet 120, and the encapsulant 118 is melt and may fill the space between the cover sheet 130 and the back sheet 120 during the lamination process. Of course, the encapsulant 118 can also be disposed both between the light-receiving surface 112 of each of the solar cell units 110 and the cover sheet 130 in the solar module 100 and between the bottom surface 114 of each of the solar cell units 110 and the back sheet 120 as shown in Fig. 2.

The solar module of this disclosure has several advantages. For example, the ribs on the back sheet can align the solar cell units to maintain a space between the solar cell units and sufficiently prevent the solar cell units from being displaced during lamination process.

## Claims

1. A solar module (100), **characterized by** comprising:
a back sheet (120) comprising:
a substrate (122); and
at least one rib (124) formed on the substrate (122);
at least one solar cell unit (110) disposed on the back sheet (120) next to the rib (124), the solar cell unit (110) comprising:
a bottom surface (114) facing the back sheet (120); and
a light-receiving surface (112) opposite to the bottom surface (114);
and
a cover sheet (130) disposed on the solar cell unit (110),
wherein a first height from a top surface of the substrate (122) to an upper end of the rib (124) is greater than a second height from the top surface of the substrate (122) to the bottom surface (114) of the solar cell unit (110), and the first height is not greater than a third height from the top surface of the substrate (122) to a lower surface of the cover sheet (130) facing the solar cell unit (110).

2. A solar module (100), **characterized by** comprising:
a back sheet (120) comprising:
a substrate (122); and
a rib (124) formed on the substrate (122);
two solar cell units (110) disposed on the substrate (122) and disposed at opposite sides of the rib (124), wherein each of the solar cell units (110) comprises:
a bottom surface (114) facing the back sheet (120); and
a light-receiving surface (112) opposite to bottom surface (114); and a cover sheet (130) disposed on the solar cell units (110),
wherein a first height from a top surface of the substrate (122) to an upper end of the rib (124) is greater than a second height from the top surface of the substrate (122) to the bottom surface (114) of each of the solar cell units (110), and the first height is not greater than a third height from the top surface of the substrate (122) to a lower surface of the cover sheet (130) facing the solar cell units (110).

3. A solar module (100), **characterized by** comprising:
a back sheet (120) comprising:
a substrate (122); and
a plurality of ribs (124) formed on the substrate (122), wherein a plurality of receiving spaces are defined by the ribs (124);
a plurality of solar cell units (110) disposed on the back sheet (120), wherein the solar cell units (110) are disposed in the receiving spaces respectively, each of the solar cell units (110) comprising:
a bottom surface (114) facing the back sheet (120); and
a light-receiving surface (112) opposite to the bottom surface (114); and
a cover sheet (130) disposed on the solar cell units (110),
wherein a first height from a top surface of the substrate (122) to an upper end of each of the ribs (124) is greater than a second height from the top surface of the substrate (122) to the bottom surface (114) of each of the solar cell units (110), and the first height is not greater than a third height from the top surface of the substrate (122) to a lower surface of the cover sheet (130) facing the solar cell units (110).

4. A solar module (100), **characterized by** comprising:
a back sheet (120) comprising:
a substrate (122); and
at least one rib (124) formed at one side of the substrate (122);
at least one solar cell unit (110) disposed on the side of the substrate (122) next to the rib (124), the solar cell unit (110) comprising:
a bottom surface (114) facing the back sheet (120); and
a light-receiving surface (112) opposite to the bottom surface (114); and
a cover sheet (130) disposed at one side opposite to the solar cell unit (110),
wherein a first height from a top surface of the substrate (122) to an upper end of the rib (124) is greater than a second height from the top surface of the substrate (122) to the bottom surface (114) of the solar cell unit (110).

5. The solar module (100) of claim 4, **characterized in that** the first height is not greater than a third height from the top surface of the substrate (122) to a lower surface of the cover sheet (130) facing the solar cell unit (110).

6. The solar module (100) of claim 1, 2, 3, 4 or 5, **characterized in that** a sectional profile of the rib (124) is a protrusion.

7. The solar module (100) of claim 1, 2, 3, 4 or 5, **characterized in that** a sectional profile of the rib (124) is triangular, a conical, a spherical, a trapezoidal, or bullet-shaped.

8. The solar module (100) of claim 1, 2, 3, 4 or 5, **characterized in that** the rib (124) has at least one side surface facing the solar cell unit (110) obliquely.

9. The solar module (100) of claim 1, 2, 3, 4 or 5, **characterized in that** the rib (124) is a solid structure or a hollow structure.

10. The solar module (100) of claim 1, 2, 3, 4 or 5, **characterized in that** a plurality of the ribs (124) are formed in a parallel array or a lattice array.

11. The solar module (100) of claim 1, 2, 3, 4 or 5, **characterized by** further comprising an encapsulant (118) disposed between the light-receiving surface (112) of the solar cell unit (110) and the cover sheet (130).

12. The solar module (100) of claim 1, 2, 3, 4 or 5, **characterized by** further comprising an encapsulant (118) disposed between the bottom surface (114) of the solar cell unit (110) and the back sheet (120).

13. The solar module (100) of claim 1, 2, 3, 4 or 5, **characterized in that** the rib (124) and the substrate (122) are integrally formed.

14. The solar module (100) of claim 1, 2, 3, 4 or 5, **characterized in that** a plurality of the ribs (124) surround the at least one solar cell unit (110).

15. The solar module (100) of claim 14, **characterized in that** the rib (124) and the substrate (122) are integrally formed.
